# FASCICULE DE BREVET EUROPEEN

(11) **EP 3 300 253 B1**
(45) Date de publication et mention de la délivrance du brevet: **14.08.2019**
(21) Numéro de dépôt: 17192721.3
(22) Date de dépôt: 22.09.2017
(51) Int. Cl.: H03K 17/082, H03K 17/16

(54) **PROCÉDÉ DE PILOTAGE D'UN TRANSISTOR DU TYPE IGBT ET DISPOSITIF DE PILOTAGE ASSOCIÉ**
VERFAHREN ZUM STEUERN EINES IGBT-TRANSISTORS, UND ENTSPRECHENDE STEUERUNGSVORRICHTUNG
CONTROLLING METHOD OF A TRANSISTOR OF TYP IGBT AND ASSOCIATED CONTROLLING DEVICE

(30) Priorité: 23.09.2016 FR 1658986
(43) Date de publication de la demande: 28.03.2018
(73) Titulaire: ALSTOM Transport Technologies, 93400 Saint-Ouen (FR)
(72) Inventeur: ANDRIANOELISON, Florent, 65800 Aureilhan (FR); RABASSE, Eric, 65310 Horgues (FR); BOISTEAU, Stephane, 86280 Saint Benoit (FR)
(74) Mandataire: Lavoix

(56) Documents cités:
- WO-A1-2014/009668
- TAKIZAWA S ET AL: "A new di/dt control gate drive circuit for IGBTs to reduce EMI noise and switching losses", POWER ELECTRONICS SPECIALISTS CONFERENCE, 1998. PESC 98 RECORD. 29TH A NNUAL IEEE FUKUOKA, JAPAN 17-22 MAY 1998, NEW YORK, NY, USA,IEEE, US, vol. 2, 17 mai 1998 (1998-05-17), pages 1443-1449, XP010294730, DOI: 10.1109/PESC.1998.703241 ISBN: 978-0-7803-4489-1

## Description

La présente invention concerne un procédé de pilotage d'un transistor du type IGBT et un dispositif de pilotage associé.

De manière connue en soi, un transistor du type IGBT (de l'anglais « *Insulated Gate Bipolar Transistor*») appelé également transistor bipolaire à grille isolée, comprend trois bornes ou contacts électriques, à savoir une grille, un collecteur et un émetteur.

Un transistor du type IGBT est particulièrement utilisable comme interrupteur électrique. En effet, un tel transistor définit un état passant dans lequel le collecteur est connecté électriquement à l'émetteur et un état bloqué dans lequel ils sont isolés électriquement l'un de l'autre.

La commutation entre les deux états est pilotée par une tension de consigne appliquée sur la grille par des moyens de commande adaptés.

En particulier, la commutation entre l'état bloqué et l'état passant comprend une phase de commutation à l'amorçage consistant à commuter le transistor de l'état bloqué vers l'état passant, et une phase de commutation au blocage consistant à commuter le transistor de l'état passant vers l'état bloqué.

Chacune de ces phases comprend plusieurs étapes intermédiaires correspondant à différents états intermédiaires du transistor entre l'état bloqué et l'état passant.

Généralement, le pilotage du transistor est adapté pour assurer un bon déroulement de ces étapes intermédiaires et garantir une vitesse constante de la commutation.

Pour ce faire, les moyens de commande associés au transistor appliquent différents courants à la grille en fonction de chaque étape intermédiaire en cours.

Il est donc important de pouvoir détecter chacune de ces étapes intermédiaires pour assurer le pilotage d'un transistor.

Selon des méthodes connues dans l'état de la technique, la détection des étapes intermédiaires est effectuée en mesurant la tension entre le collecteur et l'émetteur, et l'intensité du courant électrique passant via le collecteur.

Toutefois, afin de déterminer précisément les moments de transition entre les étapes intermédiaires, il est nécessaire de fournir aux moyens de commande des mesures de tension et d'intensité du courant passant par le transistor de manière particulièrement précise.

On conçoit alors que ceci rend la structure du circuit électrique associé au transistor plus complexe. Ce problème dévient particulièrement pertinent pour des transistors utilisés dans le domaine ferroviaire et fonctionnant alors sur la haute tension.

En particulier, on connait du document WO 2014/009668 A1 et de l'article TAKIZAWA S ET AL : « A new di/dt control gate circuit fo IGBTs to reduce EMI noise and switching losses » des procédés de pilotage d'un transistor du type IGBT.

La présente invention a pour but de proposer un procédé de pilotage d'un transistor du type IGBT permettant de piloter efficacement les étapes intermédiaires lors de la commutation du transistor entre l'état bloqué et l'état passant sans complexifier la structure du circuit électrique associé au transistor.

À cet effet, l'invention a pour objet un procédé de pilotage d'un transistor du type IGBT conforme à la revendication 1.

Suivant d'autres aspects avantageux de l'invention, le procédé comprend une ou plusieurs des caractéristiques des revendications 2 à 9.

L'invention a également pour objet un dispositif de pilotage d'un transistor du type IGBT conforme à la revendication 10.

Le dispositif est apte à générer un courant de consigne dont l'intensité sur la grille du transistor prend des valeurs de consignes différentes, au moins certaines des valeurs de consignes étant choisies en fonction du signe de la dérivée temporelle du courant principal, chaque valeur de consigne étant choisie dans un ensemble de valeurs de consigne prédéterminées.

Ces caractéristiques et avantages de l'invention apparaitront à la lecture de la description qui va suivre, donnée uniquement à titre d'exemple non limitatif, et faite en référence aux dessins annexés, sur lesquels :
- la figure 1 est une vue schématique d'un circuit électrique intégrant notamment un transistor du type IGBT et un dispositif de pilotage de ce transistor selon l'invention ;
- la figue 2 est un organigramme d'une phase de commutation à l'amorçage d'un procédé de pilotage selon l'invention mis en oeuvre par le dispositif de pilotage de la figure 1 ;
- la figure 3 est une vue schématique illustrant différentes étapes de la phase de commutation à l'amorçage de la figure 2 ;
- la figue 4 est un organigramme d'une phase de commutation au blocage du procédé de pilotage ;
- la figure 5 est une vue schématique illustrant différentes étapes de la phase de commutation au blocage de la figure 4 ;
- la figure 6 est un organigramme d'une étape de détection d'un court-circuit mise en oeuvre lors de la phase de commutation à l'amorçage de la figure 2 ; et
- la figure 7 est une vue schématique illustrant l'étape de détection d'un court-circuit de la figure 6.

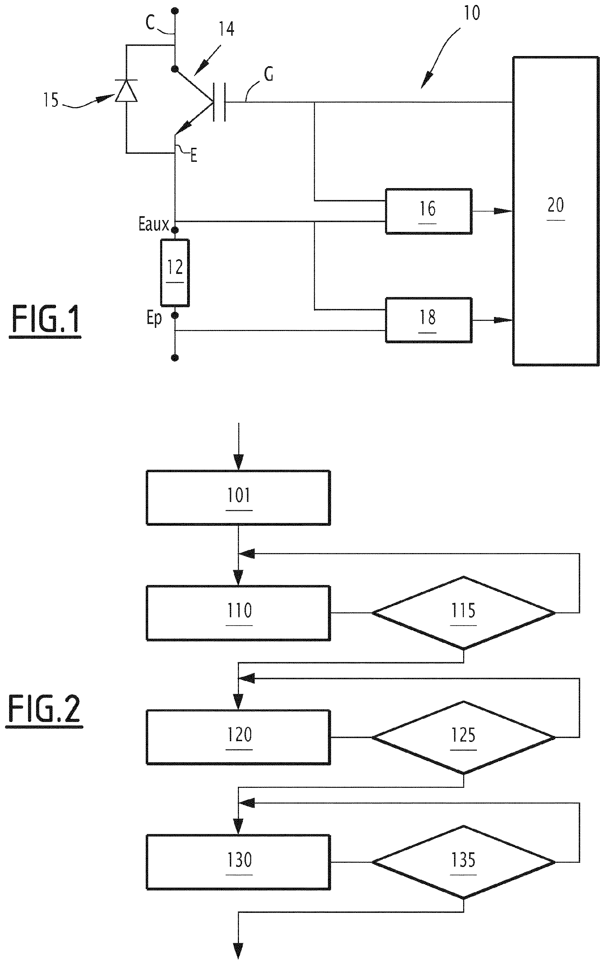

Le circuit électrique 10 de la figure 1 est utilisable pour commander au moins en partie le fonctionnement d'un composant de puissance 12 comportant notamment deux bornes Eₐᵤₓ et Eₚ.

Le circuit électrique 10 et le composant de puissance 12 sont notamment utilisables dans le domaine ferroviaire et sont, par exemple, embarqués dans un véhicule ferroviaire.

En référence à la figure 1, le circuit électrique 10 comprend un transistor 14 connecté au composant de puissance 12 et associé à une diode 15, un module de mesure de tension 16, un module de détection de changement de courant 18 et un dispositif de pilotage 20 du transistor 14 selon l'invention.

Le transistor 14 est un transistor du type IGBT (de l'anglais « *Insulated Gate Bipolar Transistor* ») appelé également transistor bipolaire à grille isolée.

Le transistor 14 est connu en soi et comporte en particulier trois bornes ou contacts électriques, à savoir, une grille G, un collecteur C et un émetteur E.

L'émetteur E est connecté notamment à la borne Eₐᵤₓ du composant de puissance 12.

Le transistor 14 définit un état passant dans lequel un courant électrique I_{c}, appelé par la suite courant principal, s'écoule entre le collecteur C et l'émetteur E et un état bloqué dans lequel le collecteur C est isolé électriquement de l'émetteur E.

Par ailleurs, la diode 15 permet le passage d'un courant électrique de l'émetteur E vers le collecteur C quel que soit l'état du transistor 14.

Le module de mesure de tension 16 est connecté d'une part à la grille G et de l'autre part à l'émetteur E du transistor 14 et permet de mesurer une tension V_{GE} entre la grille G et l'émetteur E.

Le module de mesure de tension 16 présente par exemple un voltmètre de type adapté.

Le module de mesure de changement de courant 18 est connecté aux bornes Eₐᵤₓ et Eₚ du composant de puissance 12 et permet de détecter tout changement de l'intensité du courant principal I_{C} passant par le composant électrique 12.

Autrement dit, le module 18 permet de détecter toute croissance ou toute décroissance de valeurs d'intensité du courant principal I_{C} dans le temps.

Encore autrement dit, le module 18 permet de détecter le signe de la dérivée temporelle dI_{C}/dt du courant principal I_{C}.

Pour ce faire, le module 18 est apte à mesurer la tension U entre les bornes Eₐᵤₓ et Eₚ du composant de puissance 12. Le signe de la dérivée temporelle dI_{C}/dt du courant principal I_{C} est déterminé par le signe de la tension U car la dérivée temporelle dI_{C}/dt et la tension U sont linéairement dépendantes. En effet, la tension U est égale au produit de la dérivée temporelle dI_{C}/dt et de l'inductance du composant de puissance 12.

Le dispositif de pilotage 20 est connecté à la grille G du transistor 14 et permet de piloter le fonctionnement de ce transistor 14 en appliquant une tension de consigne et un courant de consigne sur la grille G selon un procédé de pilotage 100 décrit plus en détail par la suite.

Le dispositif de pilotage 20 est connecté en outre aux modules 16 et 18 pour récupérer des mesures respectivement de la tension V_{GE} et du signe de dI_{C}/dt et à une source d'alimentation (non-illustré) fournissant une tension de consigne positive et une tension de consigne négative.

La tension de consigne positive est par exemple sensiblement égale à +15 V.

La tension de consigne négative est par exemple sensiblement égale à -15 V.

Le dispositif de pilotage 20 comprend par exemple un circuit de commande et un calculateur connecté au circuit de commande et permettant de traiter numériquement des mesures issues des modules 16 et 18 pour mettre en oeuvre au moins certaines étapes du procédé de pilotage 100.

Finalement, le dispositif de pilotage 20 est apte à recevoir un ordre d'amorçage et un ordre de blocage du transistor 14 issus par exemple d'un calculateur central (non-illustré).

Le procédé de pilotage 100 du transistor 14 sera désormais expliqué en détail.

Le procédé de pilotage 100 comprend une phase de commutation à l'amorçage, une phase d'amorçage, une phase de commutation au blocage et une phase de blocage.

Lors de la phase d'amorçage, le dispositif de pilotage 20 maintient le transistor 14 dans l'état passant en appliquant la tension de consigne positive sur la grille G.

Lors de la phase de blocage, le dispositif de pilotage 20 maintient le transistor 14 dans l'état bloqué en appliquant la tension de consigne négative sur la grille G.

La phase de commutation à l'amorçage est une phase transitoire entre la phase de blocage et la phase d'amorçage et permet notamment de faire passer le transistor 14 de l'état bloqué à l'état passant.

Un organigramme de cette phase de commutation à l'amorçage est illustré sur la figure 2.

Ainsi, en référence à cette figure 2, la phase de commutation à l'amorçage comprend une étape initiale 101 lors de laquelle le dispositif de pilotage 20 reçoit un ordre d'amorçage.

Dans ce cas, le dispositif de pilotage 20 met en oeuvre les étapes 110 à 135.

Lors d'une première étape de commutation 110, le dispositif de pilotage 20 applique à la grille G du transistor 14 la tension de consigne positive avec un courant de consigne d'intensité égale à une première valeur de consigne I_{c1}.

Lors d'une étape 115 mise en oeuvre en parallèle avec la première étape de commutation 110, le dispositif de pilotage 20 reçoit des mesures issues des modules 16 et 18, et en utilisant ces mesures, vérifie des conditions d'arrêt de la première étape de commutation 110.

En particulier, lors de cette étape 115, le dispositif de pilotage 20 continue à exécuter l'étape 110 jusqu'à ce que l'une des conditions d'arrêt suivantes soit réalisée :
- la tension du courant électrique entre la grille et l'émetteur V_{GE} atteigne un seuil de tension d'amorçage V_{ON} prédéterminé ;
- la dérivée temporelle dI_{C}/dt du courant principal I_{C} devienne positive ;
- le temps écoulé depuis le début de la première étape de commutation 110 atteigne un premier seuil temporel T₁ prédéterminé.

Le seuil de tension d'amorçage V_{ON} est paramétrable par le dispositif de pilotage 20 et réglable préalablement à la mise en oeuvre du précédé 100 par exemple entre 1 V et 20 V. Ce seuil V_{ON} est de préférence égal à 5 V.

Le premier seuil temporel T₁ est paramétrable par le dispositif de pilotage 20 et réglable préalablement à la mise en oeuvre du précédé 100 par exemple entre 1 µs et 8 µs.

La première valeur de consigne I_{c1} est paramétrable par le dispositif de pilotage 20 et réglable préalablement à la mise en oeuvre du précédé 100 par exemple entre 0,2 A et 20 A.

Puis, le dispositif de pilotage 20 exécute une deuxième étape de commutation 120 lors de laquelle il applique à la grille G du transistor 14 la tension de consigne positive avec un courant de consigne d'intensité égale à une deuxième valeur de consigne I_{c2}.

Lors d'une étape 125 mise en oeuvre en parallèle avec la deuxième étape de commutation 120, le dispositif de pilotage 20 reçoit des mesures issues du module 18, et en utilisant ces mesures, vérifie des conditions d'arrêt de la deuxième étape 120.

En particulier, lors de cette étape 125, le dispositif de pilotage 20 continue à exécuter l'étape 120 jusqu'à ce que l'une des conditions d'arrêt suivantes soit réalisée :
- la dérivée temporelle dI_{C}/dt du courant principal I_{C} devienne négative ;
- le temps écoulé depuis le début de la deuxième étape de commutation 120 atteigne un deuxième seuil temporel T₂ prédéterminé.

Le deuxième seuil temporel T₂ est paramétrable par le dispositif de pilotage 20 et réglable préalablement à la mise en oeuvre du précédé 100 par exemple entre 1 µs et 4 µs.

La deuxième valeur de consigne I_{c2} est paramétrable par le dispositif de pilotage 20 et réglable préalablement à la mise en oeuvre du précédé 100 par exemple entre 0,2 A et 20 A.

Puis, le dispositif de pilotage 20 exécute une troisième étape de commutation 130 lors de laquelle il applique à la grille G du transistor 14 la tension de consigne positive avec un courant de consigne d'intensité égale à une troisième valeur de consigne I_{c3}.

Lors d'une étape 135 mise en oeuvre en parallèle avec la deuxième étape 130, le dispositif de pilotage 20 vérifie une condition d'arrêt de la troisième étape de commutation 130.

En particulier, lors de cette étape 135, le dispositif de pilotage 20 continue à exécuter l'étape 130 jusqu'à ce que le temps écoulé depuis le début de la première étape de commutation 110 atteigne un seuil temporel d'amorçage T_{ON} prédéterminé.

Le seuil temporel d'amorçage T_{ON} est paramétrable par le dispositif de pilotage 20 et réglable préalablement à la mise en oeuvre du précédé 100 par exemple entre 3 µs et 20 µs.

La troisième valeur de consigne I_{c3} est paramétrable par le dispositif de pilotage 20 et réglable préalablement à la mise en oeuvre du précédé 100 par exemple entre 0,2 A et 20 A.

On conçoit alors que lors de la mise en oeuvre de la phase de commutation à l'amorçage, chaque valeur de consigne I_{c1} à I_{c3} est choisi dans un ensemble de valeurs de consigne prédéterminées. Ces valeurs sont prédéterminées avant la mise en oeuvre du procédé de pilotage.

Par ailleurs, les valeurs de consigne I_{c1} à I_{c3} sont différentes entre elles.

Dans l'exemple décrit, les valeurs de consigne I_{c1} à I_{c3} sont positives de sorte que la troisième valeur de consigne I_{c3} est inférieure à la première valeur de consigne I_{c1} et supérieure à la deuxième valeur de consigne I_{c2}.

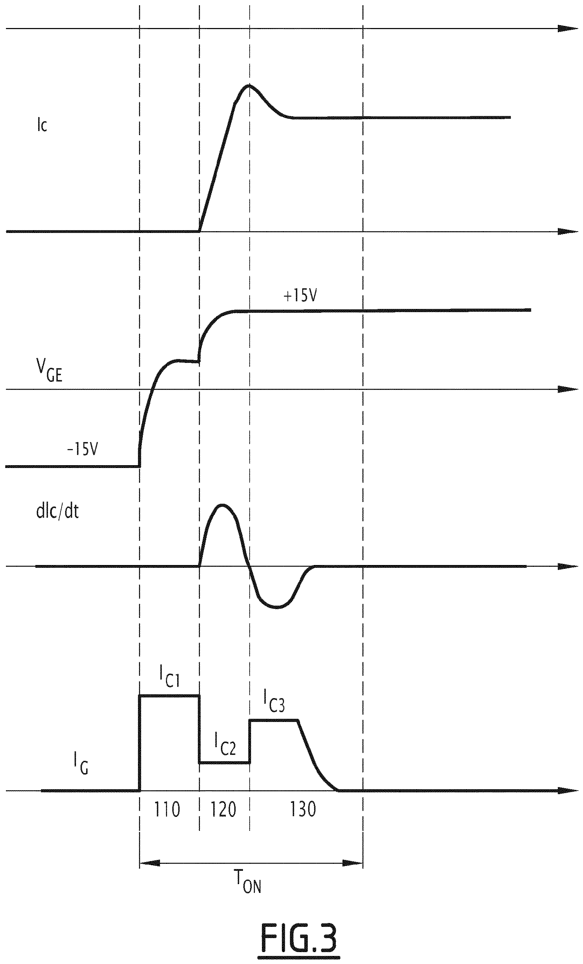

La figure 3 illustre le comportement du courant principal I_{c}, de la tension V_{GE} entre la grille G et l'émetteur E, de la dérivée temporelle dI_{C}/dt du courant principal I_{C} et du courant de consigne I_{G} à la grille G dans un exemple de la mise en oeuvre des étapes 110 à 130 de la phase de commutation à l'amorçage.

La phase de commutation au blocage est une phase transitoire entre la phase d'amorçage et la phase de blocage et permet notamment de faire passer le transistor 14 de l'état passant à l'état bloqué.

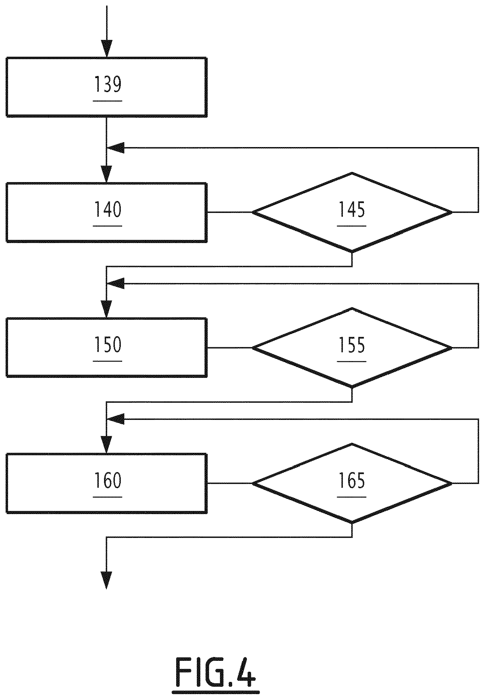

Un organigramme de cette phase de commutation au blocage est illustré sur la figure 4.

Ainsi, en référence à cette figure 4, la phase de commutation au blocage comprend une étape initiale 139 lors de laquelle le dispositif de pilotage 20 reçoit un ordre de blocage.

Dans ce cas, le dispositif de pilotage 20 met en oeuvre les étapes 140 à 165.

Lors d'une quatrième étape de commutation 140, le dispositif de pilotage 20 applique à la grille G du transistor 14 la tension de consigne négative avec un courant de consigne d'intensité égale à une quatrième valeur de consigne I_{c4}.

Lors d'une étape 145 mise en oeuvre en parallèle avec la quatrième étape de commutation 140, le dispositif de pilotage 20 reçoit des mesures issues des modules 16 et 18, et en utilisant ces mesures, vérifie des conditions d'arrêt de la quatrième étape de commutation 140.

En particulier, lors de cette étape 145, le dispositif de pilotage 20 continue à exécuter l'étape 140 jusqu'à ce que l'une des conditions d'arrêt suivantes soit réalisée :
- la tension du courant électrique V_{GE} entre la grille G et l'émetteur E atteigne un seuil de tension de blocage V_{OFF} prédéterminé ;
- la dérivée temporelle dI_{C}/dt du courant principal I_{C} devienne négative ;
- le temps écoulé depuis le début de la quatrième étape de commutation 140 atteigne un quatrième seuil temporel T₄ prédéterminé.

Le seuil de tension de blocage V_{OFF} est paramétrable par le dispositif de pilotage 20 et réglable préalablement à la mise en oeuvre du précédé 100 par exemple entre 0,5 V et 20 V. Ce seuil V_{OFF} est de préférence égal à 2 V.

Le quatrième seuil temporel T₄ est paramétrable par le dispositif de pilotage 20 et réglable préalablement à la mise en oeuvre du précédé 100 par exemple entre 1 µs et 10 µs.

La valeur absolue de la quatrième valeur de consigne I_{c4} est paramétrable par le dispositif de pilotage 20 et réglable préalablement à la mise en oeuvre du précédé 100 par exemple entre 0,2 A et 20 A.

Puis, le dispositif de pilotage 20 exécute une cinquième étape de commutation 150 lors de laquelle il applique à la grille G du transistor 14 la tension de consigne négative avec un courant de consigne d'intensité égale à une cinquième valeur de consigne I_{c5}.

Lors d'une étape 155 mise en oeuvre en parallèle avec la cinquième étape 150, le dispositif de pilotage 20 vérifie une condition d'arrêt de la cinquième étape de commutation 150.

En particulier, lors de cette étape 155, le dispositif de pilotage 20 continue à exécuter l'étape 150 jusqu'à ce que le temps écoulé depuis le début de la cinquième étape de commutation 150 atteigne un cinquième seuil temporel T₅ prédéterminé.

Le cinquième seuil temporel T₅ est paramétrable par le dispositif de pilotage 20 et réglable préalablement à la mise en oeuvre du précédé 100 par exemple entre 0,5 µs et 2 µs.

La valeur absolue de la cinquième valeur de consigne I_{c5} est paramétrable par le dispositif de pilotage 20 et réglable préalablement à la mise en oeuvre du précédé 100 par exemple entre 0,2 A et 20 A.

Puis, le dispositif de pilotage 20 exécute une sixième étape de commutation 160 lors de laquelle il applique à la grille G du transistor 14 la tension de consigne négative avec un courant de consigne d'intensité égale à une sixième valeur de consigne I_{c6}.

Lors d'une étape 165 mise en oeuvre en parallèle avec la sixième étape de commutation 160, le dispositif de pilotage 20 vérifie une condition d'arrêt de la sixième étape de commutation 160.

En particulier, lors de cette étape 165, le dispositif de pilotage 20 continue à exécuter l'étape 160 jusqu'à ce que le temps écoulé depuis le début de la quatrième étape 140 atteigne un seuil temporel de blocage T_{OFF} prédéterminé.

Le seuil temporel de blocage T_{OFF} est paramétrable par le dispositif de pilotage 20 et réglable préalablement à la mise en oeuvre du précédé 100 par exemple entre 3 µs et 20 µs.

La valeur absolue de la sixième valeur de consigne I_{c6} est paramétrable par le dispositif de pilotage 20 et réglable préalablement à la mise en oeuvre du précédé 100 par exemple entre 0,2 A et 20 A.

On conçoit alors que lors de la mise en oeuvre de la phase de commutation au blocage, chaque valeur de consigne I_{c4} à I_{c6} est choisie dans un ensemble de valeurs de consigne prédéterminées. Ces valeurs sont prédéterminées avant la mise en oeuvre du procédé de pilotage 100.

Par ailleurs, les valeurs de consigne I_{c4} à I_{c6} sont différentes entre elles.

Dans l'exemple décrit, les valeurs de consigne I_{c4} à I_{c6} sont négatives de sorte que la sixième valeur de consigne I_{c6} est inférieure à la cinquième valeur de consigne I_{c5} et supérieure à la quatrième valeur de consigne I_{c4}.

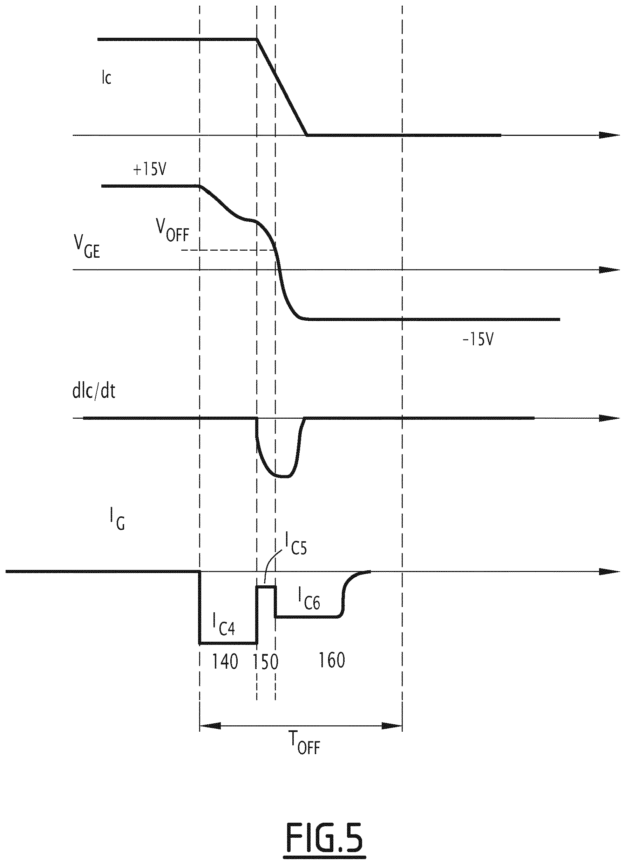

La figure 5 illustre le comportement du courant principal I_{C}, de la tension V_{GE} entre la grille G et l'émetteur E, de la dérivée temporelle dI_{C}/dt du courant principal I_{C} et du courant de consigne I_{G} à la grille G dans un exemple de la mise en oeuvre des étapes 140 à 160 de la phase de commutation au blocage.

En complément, la phase de commutation à l'amorçage comprend une étape de détection 170 d'un court-circuit dans le circuit électrique 10. Cette étape 170 est mise en oeuvre en parallèle aux étapes 110 à 135.

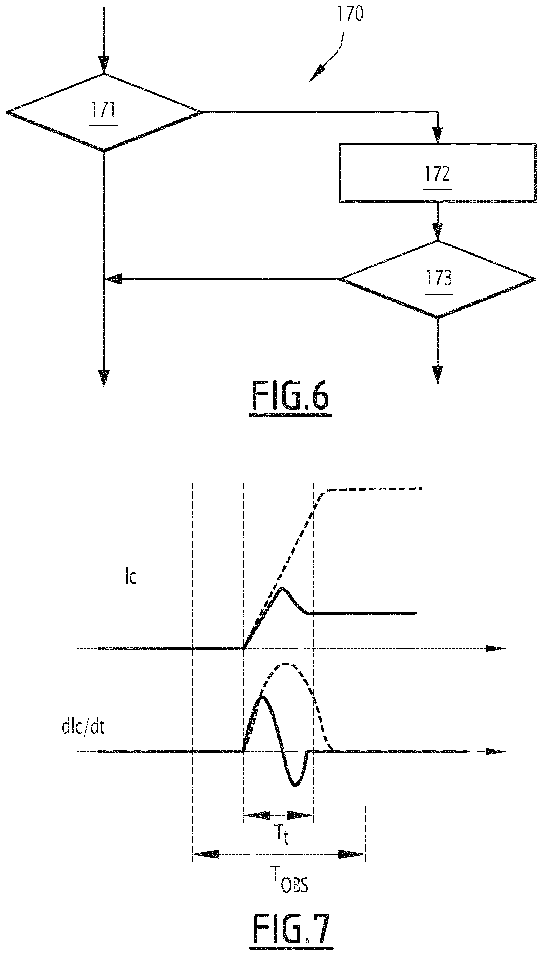

En particulier, cette étape de détection 170 comprend plusieurs sous-étapes dont l'organigramme est illustré sur la figure 6.

Lors d'une sous-étape 171, le dispositif de pilotage 20 observe le signe de la dérivée temporelle dI_{C}/dt du courant principal I_{C} dans une fenêtre temporelle d'observation T_{obs}.

Le début de la fenêtre temporelle d'observation T_{obs} correspond au début de la phase de commutation à l'amorçage.

Si la dérivée temporelle dI_{C}/dt du courant principal I_{C} est positive lors d'une période de test Tₜ prédéterminée, le dispositif 20 détecte la présence d'un court-circuit lors d'une sous-étape 172. Dans le cas contraire, le dispositif de pilotage 20 déduit qu'un court-circuit ne peut pas avoir lieu.

Avantageusement, l'étape 170 comprend en outre une sous-étape 173 lors de laquelle le dispositif 20 confirme la présence du court-circuit détecté.

En particulier, lors de cette sous-étape 173, le dispositif de pilotage 20 confirme la présence du court-circuit lorsque la dérivée temporelle dlc/dt du courant principal Ic reste supérieure ou égale à zéro pendant une période complémentaire suivant la période de test Tₜ. Dans le cas contraire, le dispositif de pilotage 20 déduit que le court-circuit n'a pas eu lieu.

La période complémentaire débute à la fin de la période de test Tₜ et se termine par exemple avec la fenêtre temporelle d'observation T_{obs}.

Lorsqu'un court-circuit a été détecté, le dispositif de pilotage 20 signale alors un court-circuit et maintien le transistor 14 dans l'état bloqué au moins pendant une période de blocage prédéterminé.

La période de test Tₜ est paramétrable par le dispositif de pilotage 20 et réglable préalablement à la mise en oeuvre du précédé 100 par exemple entre 1 µs et 10 µs.

La longueur de la fenêtre d'observation T_{obs} est paramétrable par le dispositif de pilotage 20 et réglable préalablement à la mise en oeuvre du précédé 100 par exemple entre 1 µs et 20 µs.

La période de test Tₜ et la période complémentaire sont comprises dans la fenêtre d'observation T_{obs}.

La figure 7 illustre le comportement du courant principal I_{C} et de la dérivée temporelle dI_{C}/dt du courant principal I_{C} dans deux exemples de la mise en oeuvre de la phase de commutation à l'amorçage.

Dans le premier exemple correspondant aux traits continus des courbes I_{C} et dI_{C}/dt, aucun court-circuit ne s'est produit. Dans ce cas, la dérivée dI_{C}/dt a changé le signe lors de la période de test Tₜ et le dispositif de pilotage 20 n'a donc détecté aucun court-circuit.

Dans le deuxième exemple correspondant aux traits interrompus des courbes I_{C} et dI_{C}/dt, un court-circuit a apparu. Dans ce cas, la dérivée dI_{C}/dt a été positive lors de la période de test Tₜ et égale à zéro en dehors de cette période. Le dispositif de pilotage 20 a donc détecté un court-circuit.

On conçoit alors que la présente invention présente un certain nombre d'avantages.

Le procédé de pilotage selon l'invention utilise uniquement des mesures de la tension V_{GE} entre la grille G et l'émetteur E, et le signe de la dérivée dI_{C}/dt du courtant principal I_{C} pour piloter les différentes étapes intermédiaires lors de la commutation du transistor entre l'état bloqué et l'état passant.

Il est à noter qu'aucune mesure de la valeur du courant principal I_{C} ni celle de sa dérivée dI_{C}/dt n'est nécessaire pour mettre en oeuvre le procédé. Ainsi, seul le signe de la dérivée dI_{C}/dt est important pour le pilotage du transistor ce qui permet de simplifier les exigences imposées à des différents moyens de mesure dans le circuit électrique.

Ceci simplifie alors considérablement la structure du circuit électrique intégrant le transistor.

En outre, le signe de la dérivée dI_{C}/dt du courant principal I_{C} est utilisé comme moyen de réglage pour limiter la surtension au blocage du composant de puissance.

Ainsi, aucun circuit de contre-réaction et en particulier, aucun circuit lié à la tension aux bornes du composant de puissance n'est nécessaire pour limiter la surtension au blocage. Ceci constitue alors un avantage particulier de l'invention.

## Revendications

1. Procédé de pilotage (100) d'un transistor (14) du type IGBT, le transistor (14) comportant une grille (G), un collecteur (C) et un émetteur (E), et définissant un état passant dans lequel un courant principal (I_{C}) s'écoule entre le collecteur (C) et l'émetteur (E) et un état bloqué dans lequel le collecteur (C) est isolé électriquement de l'émetteur (E) ;
le procédé (100) comportant une phase de commutation entre l'état passant et l'état bloqué comprenant la génération d'un courant de consigne dont l'intensité sur la grille du transistor (14) prend des valeurs de consignes (I_{c1},..., I_{c6}) différentes, au moins certaines des valeurs de consignes (I_{c1},..., I_{c6}) étant choisies en fonction du signe de la dérivée temporelle (dI_{C}/dt) du courant principal (I_{C}), chaque valeur de consigne (I_{c1},...,I_{c6}) étant choisie dans un ensemble de valeurs de consigne (I_{c1},...,I_{c6}) prédéterminées.

2. Procédé (100) selon la revendication 1, dans lequel la phase de commutation comprend en outre la mesure de la tension (V_{GE}) du courant électrique entre la grille (G) et l'émetteur (E) et la comparaison de cette tension avec au moins un seuil de tension (V_{ON}, V_{OFF}) prédéterminé.

3. Procédé (100) selon la revendication 2, dans lequel au moins une valeur de consigne (I_{c1},...,I_{c6}) est choisie lorsque ladite tension (V_{GE}) entre la grille (G) et l'émetteur (E) atteint le seuil de tension (V_{ON}, V_{OFF}) prédéterminé.

4. Procédé (100) selon l'une quelconque des revendications précédentes, dans lequel au moins une valeur de consigne (I_{c1},...,I_{c6}) est choisie en fonction du temps écoulé à partir du moment qu'une valeur de consigne (I_{c1},...,I_{c6}) précédente a été choisie.

5. Procédé (100) selon l'une quelconque des revendications précédentes, dans lequel la phase de commutation est une phase de commutation à l'amorçage consistant à commuter le transistor (14) de l'état bloqué vers l'état passant ou est une phase de commutation au blocage consistant à commuter le transistor (14) de l'état passant vers l'état bloqué.

6. Procédé (100) selon la revendication 5, dans lequel la phase de commutation à l'amorçage comprend les étapes suivantes mises en oeuvre de manière consécutive :
- étape préliminaire (101) d'amorçage consistant à recevoir un ordre de commutation du transistor (14) de l'état bloqué vers l'état passant ;
- première étape de commutation (110) consistant à générer le courant de consigne d'intensité égale à une première valeur de consigne (I_{c1}) jusqu'à ce que la tension du courant électrique (V_{GE}) entre la grille (G) et l'émetteur (E) atteigne un seuil de tension d'amorçage (V_{ON}) prédéterminé, ou la dérivée temporelle (dI_{C}/dt) du courant principal (I_{C}) devienne positive, ou le temps écoulé depuis le début de la première étape de commutation (110) atteigne un premier seuil temporel (T₁) prédéterminé ;
- deuxième étape de commutation (120) consistant à générer le courant de consigne d'intensité égale à une deuxième valeur de consigne (I_{c2}) jusqu'à ce que la dérivée temporelle (dI_{C}/dt) du courant principal (I_{C}) devienne négative, ou le temps écoulé depuis le début de la deuxième étape de commutation (120) atteigne un deuxième seuil temporel (T₂) prédéterminé ; et
- troisième étape de commutation (130) consistant à générer le courant de consigne d'intensité égale à une troisième valeur de consigne (I_{c3}) jusqu'à ce que le temps écoulé depuis le début de la première étape de commutation (110) atteigne un seuil temporel d'amorçage (T_{ON}) prédéterminé.

7. Procédé (100) selon la revendication 5 ou 6, dans lequel la phase de commutation au blocage comprend les étapes suivantes mises en oeuvre de manière consécutive :
- étape préliminaire (139) de blocage consistant à recevoir un ordre de commutation du transistor de l'état passant vers l'état bloqué ;
- quatrième étape de commutation (140) consistant à générer le courant de consigne d'intensité égale à une quatrième valeur de consigne (I_{c4}) jusqu'à ce que la tension (V_{GE}) du courant électrique entre la grille (G) et l'émetteur (E) atteigne un seuil de tension de blocage (V_{OFF}) prédéterminé, ou la dérivée temporelle (dI_{C}/dt) du courant principal (I_{C}) devienne négative, ou le temps écoulé depuis le début de la quatrième étape de commutation (140) atteigne un quatrième seuil temporel (T₄) prédéterminé ;
- cinquième étape de commutation (150) consistant à générer le courant de consigne d'intensité égale à une cinquième valeur de consigne (I_{c5}) jusqu'à ce que le temps écoulé depuis le début de la cinquième étape de commutation (150) atteigne un cinquième seuil temporel (T₅) prédéterminé ; et
- sixième étape de commutation (160) consistant à générer le courant de consigne d'intensité égale à une sixième valeur de consigne (I_{c6}) jusqu'à ce que le temps écoulé depuis le début de la quatrième étape de commutation (140) atteigne un seuil temporel de blocage (T_{OFF}) prédéterminé.

8. Procédé (100) selon l'une quelconque des revendications 5 à 7, dans lequel la phase de commutation à l'amorçage comprend en outre une étape (170) de détection d'un court-circuit comprenant la détection d'un court-circuit en fonction du signe de la dérivée temporelle (dI_{C}/dt) du courant principal (I_{C}) dans une fenêtre temporelle d'observation de longueur (T_{obs}) prédéterminée.

9. Procédé selon l'une quelconque des revendications 5 à 8, dans lequel le procédé comporte au moins deux phases de commutation entre l'état passant et l'état bloqué, qui sont la phase de commutation à l'amorçage et la phase de commutation au blocage.

10. Dispositif de pilotage (20) d'un transistor (14) du type IGBT, le transistor (14) comportant une grille (G), un collecteur (C) et un émetteur (E), et définissant un état passant dans lequel un courant principal (I_{C}) s'écoule entre le collecteur (C) et l'émetteur (E) et un état bloqué dans lequel le collecteur (C) est isolé électriquement de l'émetteur (E) ;
le dispositif étant apte à générer un courant de consigne dont l'intensité sur la grille du transistor (14) prend des valeurs de consignes (I_{c1},...,I_{c6}) différentes, au moins certaines des valeurs de consignes (I_{c1},...,I_{c6}) étant choisies en fonction du signe de la dérivée temporelle (dI_{C}/dt) du courant principal (I_{c}), chaque valeur de consigne (I_{c1},...,I_{c6}) étant choisie dans un ensemble de valeurs de consigne (I_{c1},...,I_{c6}) prédéterminées.

## Patentansprüche

1. Verfahren (100) zum Ansteuern eines Transistors (14) vom IGBT-Typ, wobei der Transistor (14) ein Gate (G), einen Kollektor (C) und einen Emitter (E) aufweist und einen leitenden Zustand, in dem ein Hauptstrom (I_{C}) zwischen dem Kollektor (C) und dem Emitter (E) fließt, und einen gesperrten Zustand aufweist, in dem der Kollektor (C) vom Emitter (E) elektrisch isoliert ist;
wobei das Verfahren (100) eine Phase zum Schalten zwischen dem leitenden Zustand und dem gesperrten Zustand aufweist, die das Erzeugen eines Sollstroms aufweist, dessen Stärke am Gate des Transistors (14) unterschiedliche Sollwerte (I_{c1},. .., I_{c6}) annimmt, wobei zumindest einige der Sollwerte (I_{c1}, ..., I_{c6}) abhängig von dem Vorzeichen der zeitlichen Ableitung (dI_{C}/dt) des Hauptstroms (I_{C}) gewählt werden, wobei jeder Sollwert (I_{c1}, ..., I_{c6}) aus einer Menge vorbestimmter Sollwerte (I_{c1}, ..., I_{c6}) ausgewählt wird.

2. Verfahren (100) nach Anspruch 1, wobei die Schaltphase ferner das Messen der Spannung (V_{GE}) des elektrischen Stroms zwischen dem Gate (G) und dem Emitter (E) und das Vergleichen dieser Spannung mit mindestens einer vorgegebenen Spannungsschwelle (V_{ON}, V_{OFF}) aufweist.

3. Verfahren (100) nach Anspruch 2, wobei mindestens ein Sollwert (I_{c1}, ..., I_{c6}) ausgewählt wird, wenn die Spannung (V_{GE}) zwischen dem Gate (G) und dem Emitter (E) die vorgegebene Spannungsschwelle (V_{ON}, V_{OFF}) erreicht.

4. Verfahren (100) nach einem der vorhergehenden Ansprüche, wobei mindestens ein Sollwert (I_{c1}, ..., I_{c6}) in Abhängigkeit von der verstrichenen Zeit ab dem Zeitpunkt, zu dem ein Sollwerts (I_{c1}, ..., I_{c6}) ausgewählt wurde, ausgewählt wird.

5. Verfahren (100) nach einem der vorhergehenden Ansprüche, wobei die Schaltphase eine Schaltphase zum Zünden ist, die aus dem Schalten des Transistors (14) vom gesperrten Zustand in den leitenden Zustand besteht, oder eine Schaltphase zum Sperren ist, die aus dem Schalten des Transistors (14) vom leitenden Zustand in den gesperrten Zustand besteht.

6. Verfahren (100) nach Anspruch 5, wobei die Schaltphase zum Zünden die folgenden nacheinander ausgeführten Schritte aufweist:
- Einleitender Schritt (101) zum Zünden, der aus dem Empfangs eines Befehls zum Schalten des Transistors (14) vom gesperrten in den leitenden Zustand besteht;
- erster Schaltschritt (110), der aus dem Erzeugen des Sollstroms mit einer Stärke gleich einem ersten Sollwert (I_{c1}) besteht, bis die Spannung des elektrischen Stroms (V_{GE}) zwischen dem Gate (G) und dem der Emitter (E) eine vorbestimmte Zündspannungsschwelle (V_{ON}) erreicht oder die Zeitableitung (dI_{C} / dt) des Hauptstroms (IC) positiv wird oder die Zeit, die seit dem Beginn des ersten Schaltschritts (110) verstrichen ist, eine erste vorgegebene Zeitschwelle (T₁) erreicht;
- zweiter Schaltschritt (120), der aus dem Erzeugen des Sollstroms mit einer Stärke gleich einem zweiten Sollwert (I_{c2}) besteht, bis die Zeitableitung (dI_{C}/dt) des Hauptstroms (IC) negativ wird, oder die seit dem Beginn des zweiten Schaltschritts (120) verstrichene Zeit eine zweite vorbestimmte Zeitschwelle (T₂) erreicht; und
- dritter Schaltschritt (130), der aus dem Erzeugen des Sollstroms gleich einem dritten Sollwert (I_{c3}) besteht, bis die seit Beginn des ersten Schaltschritts (110) verstrichene Zeit eine vorbestimmte Zeitsteuerungsschwelle (T_{ON}) erreicht.

7. Verfahren (100) nach Anspruch 5 oder 6, wobei die Schaltphase zum Sperren die folgenden nacheinander ausgeführten Schritte aufweist:
- Einleitender Schritt (139) zum Sperren, der aus dem Empfangen eines Befehls zum Schalten des Transistors von dem leitenden Zustand in den sperrenden Zustand besteht;
- vierter Schaltschritt (140), der aus dem Erzeugen des Sollstroms mit einer Stärke gleich einem vierten Sollwert (I_{c4}) besteht, bis die Spannung (V_{GE}) des elektrischen Stroms zwischen dem Gate (G) und dem Emitter (E) eine vorbestimmte Sperrspannungsschwelle (V_{OFF}) erreicht oder die Zeitableitung (dI_{C} / dt) des Hauptstroms (I_{C}) negativ wird oder die Zeit, die seit dem Beginn des vierten Schaltschritts (140) verstrichen ist, eine vierte vorbestimmte Zeitschwelle erreicht (T4);
- fünfter Schaltschritt (150), der aus dem Erzeugen des Sollstroms mit einer Stärke gleich einem fünften Sollwert (Ic₅), besteht, bis die seit dem Start des fünften Schaltschritts (150) verstrichene Zeit eine fünfte vorbestimmte Zeitschwelle (T5) erreicht; und
- sechster Schaltschritt (160), der aus dem Erzeugen des Sollstroms mit einer Stärke gleich einem sechsten Sollwert (Ic₆) besteht, bis die seit dem Beginn des vierten Schaltschritts (140) verstrichene Zeit eine vorbestimmte Zeitblockierungsschwelle (T_{OFF}) erreicht.

8. Verfahren (100) nach einem der Ansprüche 5 bis 7, wobei die Schaltphase zum Zünden ferner einen Kurzschlusserfassungsschritt (170) aufweist, der das Erfassen eines Kurzschlusses abhängig von dem Vorzeichen der Zeitableitung (dI_{C} / dt) des Hauptstroms (I_{C}) in einem vorgegebenen Zeitbeobachtungsfenster (T_{obs}) aufweist.

9. Verfahren nach einem der Ansprüche 5 bis 8, wobei das Verfahren mindestens zwei Schaltphasen zwischen dem leitenden Zustand und dem gesperrten Zustand aufweist, die die Schaltphase zum Zünden und die Schaltphase zum Sperren sind.

10. Steuervorrichtung (20) für einen Transistor (14) vom IGBT-Typ, wobei der Transistor (14) ein Gate (G), einen Kollektor (C) und einen Emitter (E) aufweist und einen leitenden Zustand, in dem ein Hauptstrom (IC) zwischen dem Kollektor (C) und dem Emitter (E) fließt, und einen gesperrten Zustand, in dem der Kollektor (C) vom Emitter (E) elektrisch isoliert ist, aufweist;
wobei die Vorrichtung einen Sollstrom erzeugen kann, dessen Stärke am Gate des Transistors (14) unterschiedliche Sollwerte (I_{c1}, ..., I_{c6}) annimmt, wobei zumindest einige der Sollwerte (I_{c1}, ..., I_{c6}) abhängig von dem Vorzeichen der Zeitableitung (dI_{C}/dt) des Hauptstroms (IC) gewählt werden, wobei jeder Sollwert (Ic₁, ..., Ic₆) aus einer Menge von vorgegebenen Sollwerten (I_{c1}, ..., I_{c6}) ausgewählt wird.

## Claims

1. A control method (100) for a transistor (14) of the IGBT type, the transistor (14) comprising a gate (G), a collector (C) and an emitter (E), and defining an on state in which a main current flows (I_{C}) between the collector (C) and the emitter (E) and an off state in which the collector (C) is electrically isolated from the emitter (E);
the method (100) including a phase for switching between the on state and the off state comprising generating a setpoint current, the intensity of which on the gate of the transistor (14) assumes different setpoint values (I_{c1},...,I_{c6}), at least some of the setpoint values (I_{c1},...,I_{c6}) being chosen as a function of the sign of the temporal derivative (dlc/dt) of the main current (I_{c}), each setpoint value (I_{c1},...,I_{c6}) being chosen from a set of predetermined setpoint values (I_{c1},..,I_{c6}).

2. The method (100) according to claim 1, wherein the switching phase further comprises measuring the voltage (V_{GE}) of the electrical current between the gate (G) and the emitter (E) and comparing this voltage with at least one predetermined voltage threshold (V_{ON}, V_{OFF}).

3. The method (100) according to claim 2, wherein at least one setpoint value (I_{c1},...,I_{c6}) is chosen when said voltage (V_{GE}) between the gate (G) and the emitter (E) reaches the predetermined voltage threshold (V_{ON}, V_{OFF}).

4. The method (100) according to any one of the preceding claims, wherein at least one setpoint value (I_{c1},...,I_{c6}) is chosen as a function of the time elapsed from the moment when a previous setpoint value (I_{c1},...,I_{c6}) was chosen.

5. The method (100) according to any one of the preceding claims, wherein the switching phase is a phase for switching to triggering consisting of switching the transistor (14) from the off state to the on state or a phase for switching to blocking consisting of switching the transistor (14) from the on state to the off state.

6. The method (100) according to claim 5, wherein the phase for switching to triggering comprises the following steps, carried out consecutively:
- preliminary triggering step (101) consisting of receiving an order to switch the transistor (14) from the off state to the on state;
- first switching step (110) consisting of generating the setpoint current (I_{c1}) with an intensity equal to a first setpoint value (I_{c1}) until the voltage of the electrical current (V_{GE}) between the gate (G) and the emitter (E) reaches a predetermined triggering voltage threshold (V_{ON}), or the temporal derivative (d_{IC}/dt) of the main current (I_{c}) becomes positive, or the time elapsed since the beginning of the first switching step (110) reaches a first predetermined time threshold (T₁);
- second switching step (120) consisting of generating the setpoint current with an intensity equal to a second setpoint value (I_{c2}) until the temporal derivative (d_{IC}/dt) of the main current (I_{C}) becomes negative, or the time elapsed since the beginning of the second switching step (120) reaches a second predetermined time threshold (T2); and
- third switching step (130) consisting of generating the setpoint current with an intensity equal to a third setpoint value (I_{c3}) until the time elapsed since the beginning of the first switching step (110) reaches a predetermined triggering time threshold (T_{ON}).

7. The method (100) according to claim 5 or 6, wherein the phase for switching to blocking comprises the following steps, carried out consecutively:
- preliminary blocking step (139) consisting of receiving an order to switch the transistor from the on state to the off state;
- fourth switching step (140) consisting of generating the setpoint current with an intensity equal to a fourth setpoint value (I_{c4}) until the voltage (V_{GE}) of the electrical current between the gate (G) and the emitter (E) reaches a predetermined blocking voltage threshold (V_{OFF}), or the temporal derivative (dlc/dt) of the main current (I_{C}) becomes negative, or the time elapsed since the beginning of the fourth switching step (140) reaches a fourth predetermined time threshold (T₄);
- fifth switching step (150) consisting of generating the setpoint current with an intensity equal to a fifth setpoint value (I_{c5}) until the time elapsed since the beginning of the fifth switching step (150) reaches a fifth predetermined time threshold (T5); and
- sixth switching step (160) consisting of generating the setpoint current with an intensity equal to a sixth setpoint value (I_{c6}) until the time elapsed since the beginning of the fourth switching step (140) reaches a predetermined blocking time threshold (T_{OFF}).

8. The method (100) according to any one of claims 5 to 7, wherein the phase for switching to triggering further comprises a step (170) for detecting a short-circuit comprising the detection of a short-circuit as a function of the sign of the temporal derivative (dlc/dt) of the main current (I_{C}) in an observation time window (T_{obs}) having a predetermined length.

9. The method according to any one of claims 5 to 8, wherein the method includes at least two phases for switching between the on state and the off state, which are the phase for switching to triggering and the phase for switching to blocking.

10. A control device (20) for a transistor (14) of the IGBT type, the transistor (14) comprising a gate (G), a collector (C) and an emitter (E), and defining an on state in which a main current flows (I_{C}) between the collector (C) and the emitter (E) and an off state in which the collector (C) is electrically isolated from the emitter (E);
the device being able to generate a setpoint current, the intensity of which on the gate of the transistor (14) assumes different setpoint values (I_{c1},...,I_{c6}), at least some of the setpoint values (I_{c1},...,I_{c6}) being chosen as a function of the sign of the temporal derivative (dlc/dt) of the main current (I_{c}), each setpoint value (I_{c1},...,I_{c6}) being chosen from a set of predetermined setpoint values (I_{c1},...,I_{c6}).
